(19) Europäisches Patentamt

European Patent Office

Office européen des brevets

(11) **EP 0 441 156 B1**

(12) **EUROPEAN PATENT SPECIFICATION**

(45) Date of publication and mention
of the grant of the patent:
**03.01.1996 Bulletin 1996/01**

(51) Int Cl.6: **H01L 29/775**, H01L 29/96
// H03K19/094, H01L101/00

(21) Application number: **91100689.8**

(22) Date of filing: **21.01.1991**

(54) **Electron-wave coupled semiconductor switching device**

Elektronenwellegekoppelte Halbleiterschaltanordnung

Dispositif semi-conducteur de commutation, à couplage par onde électronique

(84) Designated Contracting States:
**DE FR GB IT NL**

(30) Priority: **23.01.1990 EP 90101333**

(43) Date of publication of application:
**14.08.1991 Bulletin 1991/33**

(73) Proprietor: **Max-Planck-Gesellschaft zur Förderung der Wissenschaften e.V. D-37073 Göttingen (DE)**

(72) Inventors:
• **Tsukada, Noraki, Dr.**
  **Shimamoto-cho, Osaka 6/8 (JP)**
• **Ploog, Klaus, Dr.**
  **W-7000 Stuttgart 1 (DE)**

(74) Representative: **Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.) D-80506 München (DE)**

(56) References cited:
**EP-A- 0 324 999**

• **IBM TECHNICAL DISCLOSURE BULLETIN, vol. 29, no. 3, August 1986, pages 1370-1371, New York, US; "Coupled channel interference device"**
• **APPLIED PHYSICS LETTERS, vol. 48, no. 7, February 1986, pages 487-489, Woodbury, New York, US; S. DATTA et al.: "Proposed structure for large quantum interference effects"**
• **APPLIED PHYSICS LETTERS, vol. 53, no. 20, 14th November 1988, pages 1964-1966,New York, NY, US; T.L. CHEEKS et al.: "Narrow conducting channels defines by helium ion beam damage"**
• **INTERNATIONAL ELECTRON DEVICES MEETING, Technical Digest, Washington, DC, 1st -4th December 1985, pages 558-560, IEEE, New York, US; D.A. ANTONIADIS et al.:"Quantum mechanical effects in very short and very narrow channel MOSFETs"**
• **JAPANESE JOURNAL OF APPLIED PHYSICS, vol. 28, no. 10, part 1, October 1989,pages 2188-2192, Tokyo, JP; Y. TAKAGAKI et al.: "Fabrication of ballisticquantum wires and their transport properties"**

## Description

The present invention relates to an electron-wave coupled semiconductor device and has particular reference to a semiconductor switching device. More particularly the novel device proposed herein is suitable for the fast switching of an electrical signal, in particular for the switching of digital signals in a computer, it could also be used for the switching of analog signals. Furthermore, the device could be used as a signal or power divider. One of the objects of the present invention is to propose a switch device or signal or power divider based on an electron-wave coupler which is very fast in operation, is suitable for high integration and which can also preferably be used at room temperature.

So far as is known the prior art does not disclose electron-wave coupled switching devices so that the present invention relates to a new class of devices.

It is noted that quantum interference between electron channels, albeit of a different kind, was contemplated in IBM Technical Disclosure Bulletin, vol. 29, no. 3, August 1986, pages 1370-1371. In this proposal two electron channels run parallel to each other and are separated by a characteristic distance small enough that inter-channel tunnelling can occur. According to this citation, a gate is placed over a portion of only one of the channels and the voltage applied to it is able to vary quantum interference between the channels, thereby allowing control of the conductance of the channels.

In recent years there has been a great deal of interest in the physics of electronic transport in mesoscopic systems due to advances in microfabrication technology and material growth techniques. In this respect attention is drawn to the following prior art papers:

1. G. Timp, A.M. Chang, P. Mankiewich, R. Behringer, J.E. Cunningham, T. Y. Chang, and R.E. Howaed, Phys. Rev. Lett. 59, 732 (1987).

2. B.J. van Wees, H. van Houten, C.W.J. Beenakker, J.G. Williamson, L.P. Kouvenhoven, D. van der Marel, and C.T. Foxon, Phys. Rev. Lett. $\underline{60}$, 848 (1988).

3. U. Sivan, M.Heiblum, and C.P. Umbach, Phys.Rev. Lett. $\underline{62}$, 992 (1989).

4. A. Szafer and A.D. Stone, Phys. Rev. Lett. $\underline{62}$, 300 (1989).

The dimensions of mesoscopic system are smaller than the inelastic mean-free path of electrons at sufficiently low temperatures, and as a consequence the electron wave functions can extend coherently over the entire system. When the dimensions are smaller than the elastic mean-free path, the electron transport is in the ballistic regime and there is no scattering of any kind. In high mobility GaAs/AlGaAs systems, elastic means-free paths as long as 3 to 8 $\mu$m have recently been reported in several papers, for example:

5. M.L. Roukes, A.Scherer, S.J. Allen, Jr., H.G. Graighead, R.M. Ruthen, E.D. Beebe, and J.P. Habrison, Phys. Rev. Lett. $\underline{59}$, 3011 (1987).

6. R.J. Haug, A.H. MacDonald, P. Streda, and K. von Klitzing, Phys. Rev.Lett. $\underline{61}$, 2797 (1988).

7. R.W. Winkler, J.P. Kotthaus, and K.Ploog, Phys. Rev. Lett. $\underline{62}$, 1177 (1989).

The present invention is concerned with a novel device structure which utilizes the electron wave coupling between two parallel electron waveguides.

More particularly the present invention is concerned with an electron wave coupled semiconductor device in particular a semiconductor switching device, comprising a first layer of semiconducting material having a first bandgap, a second layer of material formed on said first semiconducting layer and having a second bandgap greater than the first bandgap, first and second electron waveguides formed alongside but spaced apart from each other in the first semiconducting layer adjacent the boundary between this layer and said second layer, a gate region extending over said second layer transverse to and over said electron waveguides, first contact means providing input connections to said first and second electron waveguides on one side of said gate region and further contact means providing separate output connections from said first and second electron waveguides on the opposite side of the gate region from said first contact means, wherein the dimension of the electron waveguides under said gate region, both along and transverse to said electron waveguides and also the dimension between said electron waveguides is smaller than the elastic mean free path for electrons at the operating temperature of the device.

The basic physics underlying the invention is as follows:

If an electron is initially in one of the two electron waveguides its wave function will be a linear combination of the symmetric state (energy $E_s$) and antisymmetric state (energy $E_a$) with equal amplitudes. Each state is associated with a time-dependent pure phase factor of the form exponential $(-iE_{s,a}t/\hbar)$. Because the two states have slightly different energies $\Delta E = E_a - E_s$, their phase factors advance at slightly different rates, and the resultant linear combination wave function corresponds to an electron that oscillates back and forth between the two electron waveguides with a frequency $f = \Delta E/h$. If at time $t = 0$ the electron was in one of the two electron waveguides, then it will be found in the other electron waveguide after one half period of this oscillation, that is, after the time $t_T = h/2\Delta E$, which may be considered as the time required for an electron to transfer to the other electron waveguide.

The physics of this process will be described in further detail later with reference to the accompanying drawings.

It is particularly advantageous for the electron waveguides to be channels formed by laterally constricted regions of a two-dimensional electron gas, said restricted regions representing a quasi one-dimensional electron gas.

It is particularly preferred for the subband energy levels of the isolated electron waveguides to have the same value since this ensures the full transfer of electrons between the two waveguides. If this condition is not fulfilled then the transfer is only partial, which can however have certain practical applications, for example the dividing of a signal between two channels.

In practice it is expedient to provide means for varying the voltage applied in operation to the gate region, since this enables the switching process to be finely tuned, the efficiency of switching being a function of both the length of the electron waveguides under the gate region and of the voltage applied to the gate region. Clearly the length of the electron waveguides under the gate region is set during manufacture, whereas the voltage applied to the gate region can be readily varied in use.

Since full transfer of the signal applied to one electron waveguide from that waveguide to the other is only expected with a particular gate voltage it is also to be expected that a partial transfer of the signal can be achieved with a gate voltage which differs from this particular gate voltage. I.e. the device can be operated as a signal or power divider.

A typical switching device will be a four port switching device with two inlet ports and two outlet ports. In practice this means that the first contact means will comprise first and second contacts to said first and second electron waveguides with these first and second contacts defining first and second inlet ports. The further contact means, which gain consists of separate contacts provides separate output connections or output ports from the first and second electron waveguides.

It is however also possible to realize the first contact means as a common contact to the first and second electron waveguides and to provide field generating means for generating a magnetic field perpendicular to a plane containing said first and second waveguides in the region between said common contact and said gate region. A device of this kind thus makes use of both the present invention and also of the Aharonov-Bohm effect. This arrangement allows a signal supplied to the common contact to be switched as desired to either of the output ports, i.e. to either of the two separate contacts of the further contact means. A particular advantage lies in the fact that the coupling length, i.e. the length of the electron waveguides under the gate region is reduced by one half in comparison to the four port device, which results in a corresponding increase in the switching speed.

In either case, i.e. respective of whether one is dealing with a four port or three port device, the device itself is conveniently realized as a III-V heterostructure which is characterized in that the first semiconductor layer comprises the material having the smaller band gap and in that the second layer comprises the material having the larger band gap.

In a device of this kind a two or quasi one-dimensional electron gas forming said electron waveguides is preferably formed in said first semiconductor layer adjacent said second layer by modulation doping of said second layer. The modulation doping technique is for example described in European patent application No. 87 116 451.3 or its corresponding US patent No. 4,878,095.

A particular realization of the device of the present invention is based on an AlGaAs/GaAs heterostructure which is characterized in that said first semiconducting layer comprises an intrinsic gallium arsenide layer having a thickness in the range of $1\,\mu$ to $10\,\mu$, in particular of $2\,\mu$, grown on a GaAs substrate, preferably with buffer layers therebetween. These buffer layers comprise in known manner several periods of a superlattice structure which function to prevent impurities present in the substrate from migrating into the first semiconductor layer. In this embodiment the second layer comprises an undoped $Al_{0.3}Ga_{0.7}As$ layer having a thickness in the range from 10 to 100 nm and typically 20 nm; and a modulation doping layer in the form of n-doped $Al_{0.3}Ga_{0.7}As$ is provided in said second layer. The dopant is typically silicon with a concentration in the range 1 to $3 \times 10^{18}/cm^3$, and the modulation doping layer typically has a thickness from one monolayer up to ca. 50 nm and is spaced from the boundary of said GaAs layer by a distance (undoped $Al_{0.3}Ga_{0.7}As$ spacer) in the range from 1 to 30 nm.

In a device of this kind, or indeed in any device in accordance with the invention it is necessary to provide some form of lateral confinement for the electron waveguides, i.e. lateral boundaries for the same. This can conveniently be done by converting the regions of the device on either side of the electron waveguides and inbetween the electron waveguides (but not beneath the gate electrode) to insulating material by ion implantation or ion bombardment.

If the bombardment is carried out with an ion beam of extended cross-section it is convenient to grow a cap layer on the second layer and to etch this cap layer away to form cap regions having substantially the same size and shape in plan view as the desired electron waveguides. In a GaAs/AlGaAs heterostructure the cap layer would typically be formed by a non-doped gallium arsenide layer having a thickness of 10 to 30 nm. After photoetching the gate region is then formed over the second layer and over the cap regions, and indeed is preferably a Schottky gate, for example of gold. The structure is then subjected to ion bombardment to define the electron waveguides with the energies of the ions being selected so that they affect regions to the sides of and between the electron waveguides but not the regions containing the electron waveguides or under the gate region due to the increased thickness and/or nature of the material above said electron waveguides in said cap regions.

The first contact means and the further contact means would typically comprise metallic contacts, for example gold or germanium diffused into the device, for example at 450°C for a period of 80 sec. in a gaseous environment of 80% N2 and 20% H2 at normal pressure, although helium or argon or other inert gases could also be used if desired. The contact means would normally be formed after formation of the cap regions and before deposition of the gate electrode.

The boundaries of the electron waveguides can also be "drawn" on the chip using a sharply focussed ion beam source which converts the material in its path to fully insulating material. Irrespective of whether the ion beam bombardment is carried out with a focussed ion beam or an ion beam of extended cross-section it will essentially define an H-shaped insulating structure in plan view with the vertical limbs of the H coresponding to the electron waveguides and the cross-bar to the region beneath the gate electrode.

The electron waveguides provided by the invention would typically have a thickness up to 3 nm, a width in the range 2 to $3 \times 10^2$ nm and are typically separated from each other by a distance of 2 to $3 \times 10^2$ nm. These dimensions apply to a relatively low operating temperature, for example an operating temperature at the temperature of liquid nitrogen. As the operating temperature of the device increases the dimensions have to reduce in size and one is then beginning to reach the limits of size which can be produced by current lithographic techniques. However, it is anticipated that advances in lithographic techniques will allow the invention to be realized in devices capable of operating at room temperature.

The gate region has a width in the length direction of the electron waveguides of the order of magnitude of $0.3\ \mu$ and a length transverse to the electron waveguides of the order of magnitude of $1\ \mu$. The width of the gate region of 0.3 $\mu$ corresponds to the effective coupling length of the electron waveguides.

An alternative switching device in accordance with the present invention is based on silicon and in this case the first layer comprises a p-doped silicon layer whereas the second comprises an $SiO_2$ layer, with said electron waveguides being formed by a two-dimensional electron gas in said p-doped silicon layer adjacent the boundary between said p-doped silicon layer and said $SiO_2$ layer. In this case the gate region comprises first, second and third gate electrodes, typically of aluminium or gold. In operation the voltages applied to the first and second gate electrodes are selected to separately confine the electron waves and the voltage applied to the second gate electrode, which is disposed between the first and third gate electrodes is varied to induce coupling between the electron waves and thus produce switching. The width of the second gate electrode in the length direction of the electron wave guides corresponds to the coupling length $l_c$ and the separation between the first and second gate electrodes, and between the second and third gate electrode is relatively short, for example less than 0.1 $\mu$m.

With this embodiment the cap regions are formed on the $SiO_2$ layer and typically consist of metal. The cap regions extend up to but do not touch the contacts to the electron waveguides, i.e. are spaced from the contacts by a small distance. In this embodiment the cap regions are used to concentrate electrons in the region beneath them in the first layer adjacent the boundary between the first and second layers and thus their shape and size define the shape and size of the electron waveguides in plan view. For the formation of these cap regions a full metal layer can be deposited and selectively etched away. After the cap regions have been formed a further $SiO_2$ layer is grown on top of the exposed portions of the first said $SiO_2$ layer and on top of the cap regions and the gate electrodes are then applied on top of the overlying $SiO_2$ layer. In this case the electron wave functions are controlled by the gate voltage. The voltage applied to the first and third gates should be sufficiently large to confine the electron waves under the cap layers. On the other hand the voltage applied to the second gate must be small so as to permit overlap of the electron waves of the two waveguides.

As previously mentioned a device in accordance with the present invention is well suited for high integration.

For example a plurality of electron waveguides can be provided and can be arranged parallel to one another and spaced apart in the first semiconducting layer adjacent the boundary with said second layer, with a plurality of gate regions being provided, each gate region extending over two adjacent electron waveguides. Clearly only the required input and output contacts must be provided to each electron waveguide.

In addition a series arrangement of devices in accordance with the present invention is entirely feasible.

The invention will now be described in more detail with reference to the accompanying drawings in which:

Fig. 1                    is a schematic plan view of an electron-wave coupled switching device in accordance with the present invention,

Fig. 2                    is a schematic cross-section through the device of Fig. 1 as seen on the plane II-II in Fig. 1,

| | |
|---|---|
| Fig. 3 | is a further schematic cross-section through the device of Fig. 1 as seen in the plane III-III, |
| Fig. 4 | is a plan view similar to that of Fig. 1 but showing an alternative device in accordance with the present invention which exploits the Aharonov-Bohm effect, |
| Fig. 5 | is a plan view again similar to Fig. 1 but of an alternative device based on silicon, |
| Fig. 6 | is a cross-sectional view of the device of Fig. 5 corresponding to the plane VI or VIa, |
| Fig. 7 | is a cross-sectional view of the device of Fig. 5 taken on the plane VII-VII, |
| Fig. 8 | is a plan view of a switching device similar to Fig. 1 but having three electron waveguides, |
| Fig. 9 | shows a plan view similar to Fig. 8 but having four electron waveguides and a slightly different layout, |
| Figs. 10A, 10B, 10C and 10D | explain the use of a switching device in accordance with Fig. 1 but provided with a second gate electrode in order to realise an exclusive OR gate (EOR), |
| Fig. 10E | shows a logic table of the values of the outputs of the two electron waveguides or channels for four different permutations of the two gate voltages, |
| Fig. 10F | shows how the second waveguide has an output corresponding to the function of an exclusive OR gate, |
| Figs. 11A, 11B, 11C and 11D | explain the use of a switching device in accordance with Fig. 8 to realise both an AND gate and an inverter, |
| Fig. 11E | shows that the third electron waveguide of the Fig. 11A to 11D arrangement has an output corresponding to an AND gate and that the first electron waveguide has an output which corresponds to an inverter, |
| Fig. 12A | shows how the device of Fig. 8 can be used to realise a NOR gate, |
| Fig. 12B | shows how the second electron waveguide of the embodiment of Fig. 12A has an output corresponding to a NOR gate, |
| Fig. 13A | shows how the device of Fig. 8 can be used to realise an inverter, |
| Fig. 13B | shows how the third electron waveguide of the device of Fig. 13A has an output corresponding to an inverter, |
| Fig. 14A | shows how the same device of Fig. 8 can be modified to form an OR gate, and |
| Fig. 14B | shows how the combined outputs of the first and third electron waveguides of the device of Fig. 14A realise the function of an OR gate. |

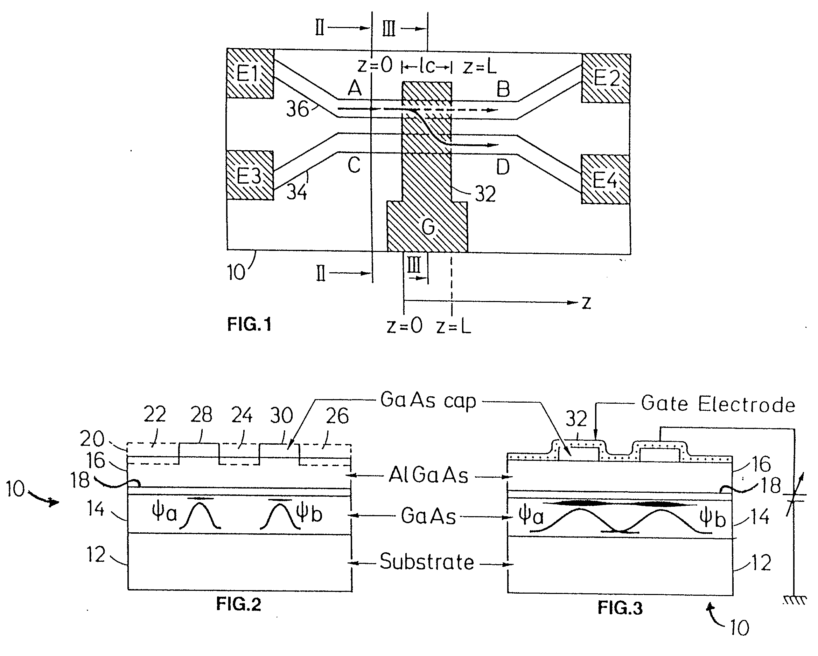

Turning firstly to the Figs. 1, 2 and 3 there can be seen a semiconductor switching device based on III-V semiconductor materials, which in this particular embodiment comprise GaAs/AlGaAs.

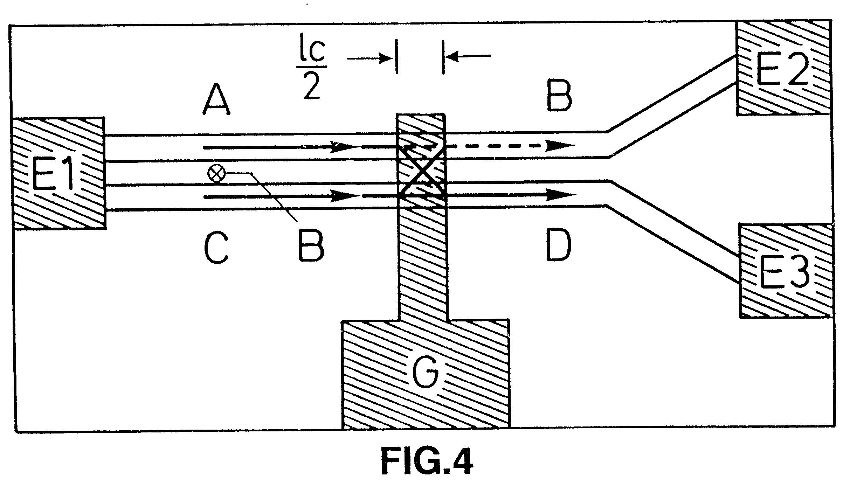

The layerwise build up of the device is most readily apparent from the cross-sections of Figs. 2 and 3.

As can be seen the device 10 comprises a substrate 12 of non-doped semi-insulating gallium arsenide which is typically about 300 μ thick. This dimension is not critical. Although non-doped material is used, it is generally found that such semi-insulating substrates, even when very carefully prepared, are still slightly p-doped but this is not of any great importance. Grown on top of the gallium arsenide substrate 12 is a first semiconductor layer 14 which again consists of intrinsic gallium arsenide which is undoped but in practice tends to be slightly p-doped. The growth technique chosen is preferably molecular beam epitaxy however other epitaxial growth methods can also be used. The gallium arsenide layer 14 is typically at least 1 $\mu$ thick and preferably 10 $\mu$ thick. In practice the semiconducting layer 14 is not grown directly onto the substrate 12, but rather intermediate buffer layers are provided which are intended to prevent any impurity present in the substrate entering into the highly pure gallium arsenide layer which is subsequently grown on top of the buffer layers. This technique is well known per se. The growth of a relatively thick layer 14 of GaAs by an epitaxial technique ensures that the layer has a high quality crystallographic structure.

On top of the GaAs layer 14 there is then grown a second layer 16 of $Al_{0.3}Ga_{0.7}As$ which is typically of 10 to 100 nm thickness and is undoped apart from a narrow layer 18 which is subjected to modulation doping and in this case is n-doped with silicon at a concentration of 1 to 3 x $10^{18}/cm^3$.

The dimensions used in the specific embodiment are in fact a thickness of 100 nm for the total second layer 16 with the spacer material between the doped layer 18 and the layer 14 having a thickness of 20 nm. The doped layer 18 itself also has a thickness of a further 20 nm and the thickness of the layer 16 above the layer 18 is then 60 nm. The layer 18 can however also be a single doped atomic plane. Its function is to provide electrons to the potential well which is created at the interface between the second layer 16 and the first layer 14 due to the different band gaps of the two different materials and these electrons are concentrated in the energetic potential well in the form of a two-dimensional electron gas.

On top of the gallium arsenide layer 16 there is then grown a gallium arsenide cap layer 20 which is of non-doped material and typically has a thickness of 10 to 30 nm. After this the device is subjected to photoetching to etch away the regions 22, 24 and 26 leaving the cap regions 28 and 30. Normally the level of the etched surface between the waveguides will be the same at all points to the side of and between the cap regions. However, in an alternative illustrated by dotted lines in Fig. 2 the side regions 22 and 26 are etched deeper than the region 24 immediately beneath the gate electrode in order to damp the effect of the later ion beam irradiation in the region of the chip beneath the gate electrode.

Having created the semiconductor device in this way four contacts E1 to E4 are then formed by diffusing gold or germanium into the semiconductor at a temperature of 450°C. The diffusion process is typically carried for 80 sec. and an atmosphere of 80% N2 and 20% H2 at normal pressure. These diffusion parameters are sufficient to ensure that the contact metals diffuse down into the boundary region between the layers 16 and 14 and make correct contact with the ends of the electron waveguides 34 and 36.

A gate electrode, for example in the form of a thin layer of gold is then deposited over the etched cap region and has the shape in cross-section which can be seen from Fig. 3 and the shape in plan view which can be seen from Fig. 1.

Following this the semiconductor device is subjected to ion beam bombardment using a wide area flux and this results in all areas of the substrate to the side of and between the cap regions 28 and 30 but not beneath the gate electrode 32 being made electrically insulating. The region of the device beneath the cap regions and beneath the gate electrode at the level of the electron waveguides is unaffected by the ion beam because of the increased material thickness and because of the metallic nature of the gate electrode which forms a barrier for the ions. The ion beam thus defines two channels 34 and 36 at the boundary between the second layer 16 and the semiconducting layer 14 with these channels functioning as electron waveguides. The shape of these channels 34 and 36 in plan view, as seen in Fig. 1, is determined by the shape given to the cap regions 28 and 30, i.e. in plan view the cap regions 28 and 30 have the same shape and size as the channels 34 and 36. It is the increased thickness of the material above the channels and also the metallic contact 32 which prevents the regions under these cap regions and under the gate electrode 32 from being converted to insulating material. The electron waveguides 34 and 36 are thus of a very shallow extent in the vertical direction in Fig. 2 or Fig. 3 and have a width and a separation from each other which is determined precisely by the position of the GaAs cap regions. In this example the cap regions have a width in the range 2 to 3 x $10^3$ Å and are spaced apart from one another by the same distance. The cap regions also have a further benefit in as much as they protect the underlying AlGaAs.

The operation of this semiconductor switching device will now be described in more detail with reference to the underlying physics.

The device as shown can be considered as having two end regions (z<0 and z>L) without coupling between the electron waveguides (EWGs) and a central region (0<z<L) consisting of a coupling region of the EWGs shown in Fig. 1. As previously described the structure has four electrodes E1-E4. The coupling strength in the central region can be controlled by the gate voltage.

In the end regions, the quasi one-dimensional electron gases are formed under the GaAs cap quantum wires (see the papers by J.S. Weiner, G. Danan, A. Pinczuk, J. Valladares, L.N. Pfeiffer, and K. West, Phys.Rev. Lett. 63, 1641 (1989); T.L. Cheeks, M.L. Roukes, A. Scherer, and H.G. Graighead, Appl. Phys. Lett. 53, 1964 (1988)). In order to obtain the coupling between EWGs in the central region, the gate voltage is controlled so that the electron wave functions of the two EWGs overlap each other in the channel plane (see the papers by M. Okada, T. Oshima, M. Matsuda, N. Yokoyama, and A. Shibatomi, Jpn.J.Appl.Phys. 27, L2424 (1988)).

According to Yariv, C. Lindsey, and U.Sivan, J.Appl.Phys. 58, 366 (1985) one can express an eigenstate $\psi(x)$ of an

electron in the coupled EWG potential V(x) as a linear combination of the wave function $\psi_{1,2}(x)$ of the two isolated EWGs, i.e.,

$$\psi(x) = a\psi_1(x) + b\psi_2(x) \tag{1}$$

where the Schrödinger equations obeyed by $\psi_{1,2}(x)$ are the single-EWG equations

$$H_{1,2}\psi_{1,2} = E_{1,2}\psi_{1,2}, \tag{2}$$

$$H_{1,2} = -\frac{\hbar}{\partial m^*} \cdot \frac{\partial^2}{\partial x^2} + V_{1,2}, \tag{3}$$

where $m^*$ is the carrier effective mass and $V_{1,2}$ the potential energy functions of the isolated EWGs.

It is now appropriate to consider the time evolution of the electron wave function after an electron is initially launched in one of the two EWGs. The time evolution of the wave function is treated by the time dependent Schrödinger equation,

$$i\hbar\,\frac{\partial\psi}{\partial t} = H\psi \tag{4}$$

where

$$H = -\frac{\hbar^2}{2m^*} \cdot \frac{\partial^2}{\partial x^2} + V_1(x) + V_2(x) - V_0, \tag{5}$$

and $V_O$ is the potential barrier height between the two EWGs. Substituting Eq. (1) into Eq. (4) and using Eqs. (2) and (3), one obtains the coupled equations for the linear combination amplitudes a and b of Eq. (1):

$$i\hbar\,\frac{da}{dt} = aE_1 + a\langle 1|V_2\text{-}V_O|1\rangle + b\langle 1|V_1\text{-}V_0|2\rangle, \tag{6a}$$

$$i\hbar\,\frac{db}{dt} = bE_2 + a\langle 2|V_2\text{-}V_0|1\rangle + b\langle 2|V_1\text{-}V_0|2\rangle. \tag{6b}$$

The explicit determination of the matrix elements involved in Eq. (6) has been carried out by using the normalized single EWG solutions $\psi_1(x)$ and $\psi_2(x)$ by Yariv et al. The elements $\langle 1|V_1\text{-}V_0|2\rangle$ and $\langle 2|V_2\text{-}V_0|1\rangle$ have a factor of the form $\exp(-Kd)$, and the elements $\langle 1|V_2\text{-}V_0|1\rangle$ and $\langle 2|V_1\text{-}V_0|2\rangle$ have a factor of the form $\exp(-2Kd)$, where K is a constant depending on the structure of the coupled EWGs and d the barrier width between the two EWGs. Consequently, one can neglect the elements of $\langle 1|V_1\text{-}V_0|1\rangle$ and $\langle 2|V_1\text{-}V_0|2\rangle$ and obtain the simple coupled equation between a and b of Eq. (1) in the simple form:

$$\frac{da}{dt} = -i\omega_1 a - ic_1 b, \tag{7a}$$

$$\frac{db}{dt} = -i\omega_2 b - ic_2 a, \tag{7b}$$

where

$$\omega_1 = E_1/\hbar, \ \omega_2 = E_2/\hbar, \ c_1 = \langle 1|V_1\text{-}V_0|2\rangle/\hbar, \ c_2 = \langle 2|V_2\text{-}V_0|1\rangle/\hbar. \tag{8}$$

This coupled equation has the same form as that for the coupled mode equation appearing in the coupling of optical modes in space (for example see N. Bloembergen, Nonlinear Optics (Benjamin, New York, 1965)) and for the Schrödinger equation for the two-level atomic system interacting with the electromagnetic (laser) field in time (for example see L. Allen and J.H. Eberly, Optical Resonance and Two-Level Atoms (Wiley, New York, 1975)).

The determinantal equation for an assumed $\exp(-i\omega t)$ dependence is,

$$(\omega\text{-}\omega_1)(\omega\text{-}\omega_2)\text{-}c_1 c_2 = 0, \tag{9}$$

with the solution

$$\omega_{\pm} = \frac{\omega_1 + \omega_2}{2} \pm \omega_0, \tag{10}$$

where

$$\omega_0 = \sqrt{\frac{(\omega_1\text{-}\omega_2)^2}{2} + c_1 c_2}. \tag{11}$$

In the coupling (central region, therefore, the two modes $\psi_1$ and $\psi_2$ of the coupled EWGs form two new modes which oscillate independently from each other, one with $\omega_+$ and the other with $\omega_-$. The difference $\Delta\omega = \omega_+\text{-}\omega_-$ causes the phase difference between the symmetric and antisymmetric state leading to the creative or destructive interference of the wave functions in each EWG. The general solution of Eq. (7) is a combination of these two modes. Suppose that the electron waves in each EWG are given as a = a(0) and b = b(0) at t = 0. For these conditions the solutions are as follows:

$$a(t) = \left[ a(0) \left( cos\omega_0 t + i\frac{\omega_2 - \omega_1}{2\omega_0} sin\omega_0 t \right) - i\frac{c}{\omega_0} b(0) sin\omega_0 t \right] e^{-i(\omega_1 + \omega_2) \, t/2} \qquad (12a)$$

$$b(t) = \left[ -i\frac{c_2}{\omega_0} a(0) sin\omega_0 t + b(0) \left( cos\omega_0 t + i\frac{\omega_1 - \omega_2}{2\omega_0} sin\omega_0 t \right) \right] e^{-i(\omega_1 + \omega_2) \, t/2} \qquad (12b)$$

For the symmetric EWG case, i.e., $\omega_1 = \omega_2$ and $c_1 = c_2 = c$ and for the initial condition of a(0) = 1 and b(0) = 0, Eq. (12) becomes very simple and the probabilities of finding the electron in each EWG are given by

$$|a(t)^2| = cos^2 ct \qquad (13a)$$

$$|b(t)^2| = sin^2 ct. \qquad (13b)$$

These equations mean that an electron, initially in one of the two coupled EWGs, is transferred to the other one at times $t = (n+1/2)\pi/c$ (n = 0,1,2,...). At time $t = n\pi/c$ the electron transfers completely back to the initially injected EWG. It should be noticed that in order to get complete electron transfer, the subband energy levels ($E_1$ and $E_2$) of the isolated EWGs should therefore have the same value. If $E_1 \neq E_2$ complete transfer is not obtained but instead partial transfer is realized.

Next it is appropriate to consider how to initially excite only one EWG and the coupling length needed for the electron transfer. It is assumed that in the isolated EWG only the lowest subband is occupied and the electron transport in the coupled region (0 < x < L) is ballistic, i.e. there is no elastic or inelastic scattering. It is also assumed that the applied potentials $eV_{12} = \mu_1 - \mu_2$ and $eV_{14} \simeq \mu_1 - \mu_4$ are not far from the Fermi energy, i.e., $eV_{12}$, $eV_{14} \approx E_F$, where $\mu_i$ (i = 1~4) is the chemical potential of the i-th electrode (M. Büttiker, Phys. Rev. Lett. 57, 1761 (1986)).

The case will first be considered in which there is no coupling between the two EWGs in the central region. In this case, the electron injected from the electrode E1 propagates from port A to port B. All electrons injected from the electrode E1 can therefore reach the electrode E2. Next, if there is any coupling between the two EWGs in the central region, the electron injected from the port A feels the existence of the other guide at the moment that the electron reaches z = 0, that is, the coupling between the EWGs begins at z = 0. This situation corresponds to the fact that an electron is initially injected in one of the two EWGs. The wave function for the injected electron is therefore a linear combination of the symmetric and antisymmetric-state of the coupled EWGs. As discussed above, the resultant linear combination wave function corresponds to an electron oscillating back and forth between the two EWGs with a frequency f = $\Delta E/h$. The electron injected at z = 0 will be found in the other well after one-half period of this oscillation, that is, after the time $t_T$ = h/2$\Delta E$.

Since it was assumed that the applied potentials are not so far from the Fermi energies, the transport is mainly due to electrons at the Fermi energies $E_F$ (see the papers by R.J. Haug, A.H. MacDonald, P.Streda, and K.von Klitzing, Phys.Rev. Lett. 61, 2797 (1988) and M. Büttiker, Phys. Rev. Lett. 57, 1761 (1986)). The velocity of electrons injected in the coupling region is therefore given by the Fermi velocity $v_F$. Therefore, after travelling the distance $l_c = v_F t_T$, the electron injected from the port A will be found in the other EWG. The coupling energy $\Delta E$ for the symmetric EWG has been evaluated by Krömer and Okamoto (H. Krömer and H. Okamoto, Jpn. J.Appl. Phys. 23, 970 (1984) and Yariv et al. Krömer and Okamoto have shown that the coupling energy $\Delta E$ = 10 meV is roughly the upper limit of the desirable inter-well coupling energies for GaAs/AlGaAs quantum well structures. Although the separation between the EWGs is relatively large for the planar device structure proposed in this paper, large coupling energies can be expected in spite of the large separation of the EWGs, because the electrons are weakly confined by the gate voltage in the coupling region. Actually Lorke et al., (A.Lorke, J.P.Kotthaus, and K.Ploog, to be published) have reported on the electrostatic generation of quantum dots that the coupling strength between dots can be tuned by the applied gate voltage and observed the coupling strength of 1~2 meV. Such coupling strengths can also be expected in the present device structure for the separation of the EWGs of d = 0.2~0.3 $\mu$m.

For the electron density of $n_3 = 10^{11}$ cm$^{-2}$, one obtains the Fermi velocity $v_F = 1.4.10^7$ cm/sec by using the relation between the Fermi velocity and the carrier density:

$$v_F = \sqrt{\frac{2E_F}{m^*}} = \frac{h}{m^*} \cdot \sqrt{\frac{n_s}{2\pi}} \qquad (14)$$

By assuming the coupling energy $\Delta E$ = 1 meV, one finds a transfer time ($t_T$) of 2 psec and a coupling length $l_c = v_F t_T = 0.28 \, \mu$m.

The RC time constant for the gate is estimated from the experimental results on the modulation-doped field-effect transistor (MODFET) (J.T. Drummond, W.T. Masselnik, and H.

Morkoc, Proc. of IEEE $\underline{74}$, 773 (1986)) to be much smaller than 0.1 psec, because the dimension of the gate for the proposed device is very small (typically 1 μm x 0.3 μm).

In EWGs of finite cross-section one has to consider both the motion of carriers transverse to the EWG and the motion along the EWG (see for example the paper by M. Büttiker, Phys. Rev. B $\underline{38}$, 9375 (1988) and the paper by C.S. Chu and R.S. Sorbello, Phys. Rev. B $\underline{40}$, 5941 (1989)). Motion in the transverse direction is quantized by a set of discrete energies $E_n$. To this energy must be added the kinetic energy for motion along the direction of the EWG, $\hbar^2 k^2/2m^*$, such that $E_F = \hbar^2 k_n^2/2m^* + E_n$. Consequently, if many transverse modes are present, the transfer ratio is degraded because the coupling lengths for different modes are slightly different from each other.

It should be mentioned that the structure of the device shown in Fig. 1 is reminiscent of the optical directional coupler in which optical waveguides interact with one another by the way of their evanescent fields. The mechanism of operation of such electrons is however completely different from the mechanism underlying the present proposal. The interaction leads to power transfer from one waveguide to the other waveguide.

A modification of the device of the present invention is shown in Fig. 4 which again shows a gallium arsenide / aluminium gallium arsenide structure having the same basic layer sequences and dimensions as shown in Figs. 2 and 3. However in the present case the first contact means on the one side of the gate region comprises a common contact E1 to both the first and second waveguides 34 and 36. This device comprises a new class of electron-wave coupled device and is based to some degree on the optical device analogy. The device shown is in fact a device where the Aharonov-Bohm (AB) effect (see the papers by S. Datta, M.R. Melloch, S. Bandyopadhyay, R. Noren, M. Vaziri, M. Miller, and R. Reinfenberger, Phys. Rev. Lett. $\underline{55}$, 2344 (1985); S. Datta, M.R. Melloch, S. Bandyopadhyay, and M.S. Lundstrom, Appl. Phys. Lett. $\underline{48}$, 487 (1986) is combined with the coupled EWG structure. In this device, the electrons are injected from both input ports A and C and these ports are subject to a perpendicular magnetic field B. therefore, the electrons travelling in the ports A and C experience the phase difference induced by the AB effect. When the phase difference φ between ports A and C becomes $2n \pm \pi/2$ (n=0,1,2,...), all electrons injected from the input ports A and C are conducted to the output ports B or D. This can be derived from the initial conditions with a(0)=1 and b(0)=exp(iφ) (see N. Tsukada, R. Tsujinishi, and K. Tomishima, J.Appl.Phys. $\underline{50}$, 4611 (1979); $\underline{51}$, 2450 (1980)). Both the switching time and the coupling length for this device become halves compared to those of the device shown in Fig. 1.

The device proposed herein is however not restricted to III-V semiconductor materials. It can for example also be realized on the basis of silicon.

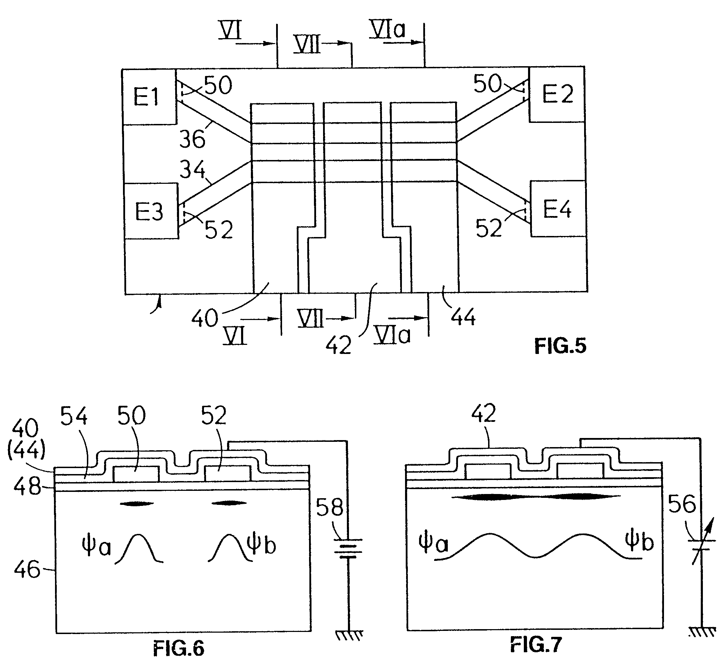

As can be seen from Fig. 5 the basic layout of the device is very similar to that of the device of Fig. 1 however the gate region 32 is formed here as three distinct gates, i.e. a first gate 40 and second gate 42 and a third gate 44.

The semiconductor device itself comprises a p-doped silicon chip 46 onto which there is deposited an insulating $SiO_2$ layer 48 and subsequently metallic cap regions 50, 52. A further layer of silicon dioxide 54 is then deposited over the silicon dioxide layer 48 and over the cap regions 50 and 52 and finally the gate electrodes are then deposited over the overlying silicon dioxide layer 54. The cap regions 50 and 52, which again have the same shape as the electron wave guides 34 and 36 are formed here of aluminium or gold. The gate electrodes 40, 42 and 44 are also formed of aluminium or gold. As with the previous embodiments the cap regions 50 and 52 can be formed by deposition of a complete layer of the relevant material followed by subsequent etching.

In this structure the metallic cap regions 50 and 52 form electron waveguide electrodes which are positively biased. These metallic cap regions extend close up to the respective contacts E1 to E4 but do not actually contact the latter, i.e. are spaced from the contacts E1 to E4 by a small distance as illustrated by the broken lines representing the ends of the cap regions. The inversion layer formed by the positively biased electron waveguide electrodes 50 and 52 is confined by the gate electrodes 40, 42 and 44. In the uncoupled regions under the gate electrodes 40 and 44 the confined gate voltage (illustrated schematically at 58 in Fig. 6) is sufficiently high to separately confine the electron waves at ψa and ψb. In the coupled region beneath the central, second gate electrode 42 the gate voltage is varied to induce the coupling between the electron waves ψa and ψb. This is illustrated schematically in Fig. 7 by the variable voltage supply 56 which is set to a potential lower than the potential 58 applied in Fig. 6 to provide confinement of the electron waves. In practice the length of the gate 42 is also $l_c$ as in the previously described gallium arsenide device. The separations of the gate electrode should be short, typically less than about 0.1 μm.

As previously mentioned the material used is p-type silicon and the first $SiO_2$ layer is formed on the starting p silicon substrate by thermal oxidation. After forming the electron waveguide electrodes 50 and 52 (again by photolithography, i.e. deposition of a full metallic layer and etching); the second $SiO_2$ layer 54 is formed on the structure by CVD oxidation prior to forming of the gate electrodes in the usual manner.

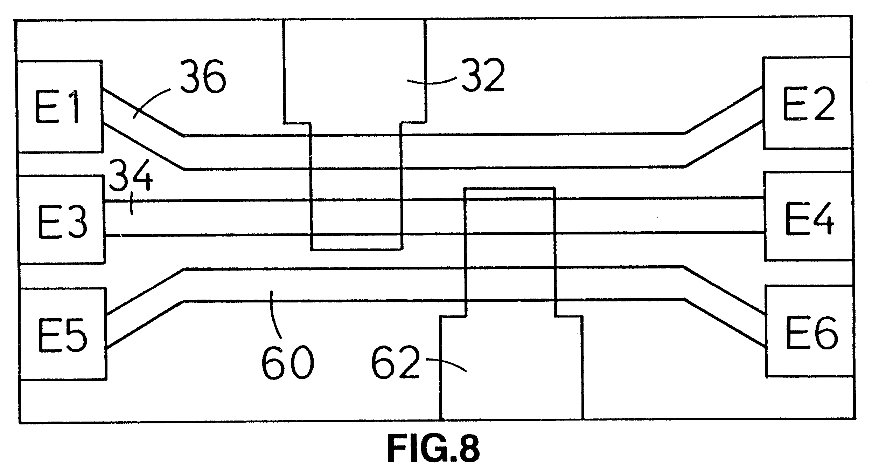

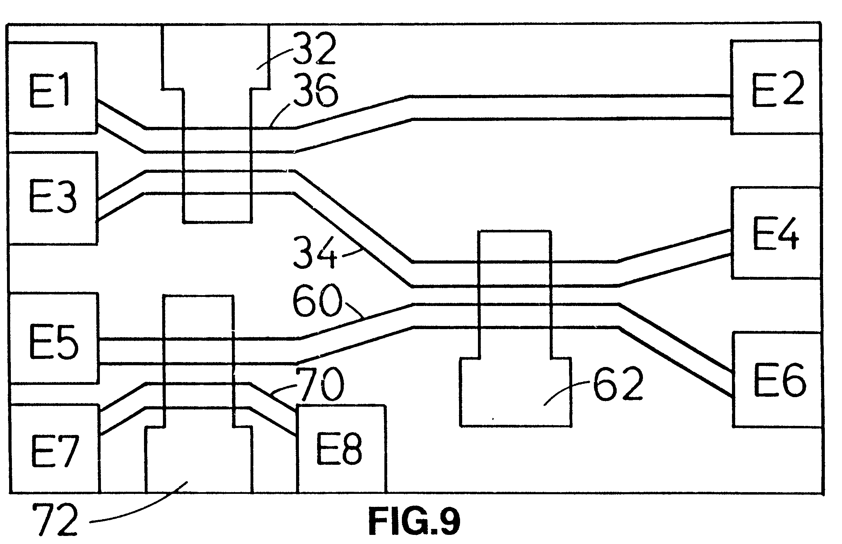

Figs. 8 and 9 shows examples of how switching devices in accordance with the present invention can be connected together, for example to form integrated circuits.

In the switching device of Fig. 8 three electron waveguides 34, 36 and 60 are provided and there are three input ports E1, E3 and E5 and three output ports E2, E4 and E6. A first gate electrode 32 is used to control the switching from the input port E3 to the input port E1 and vice versa so that the structure defined by E1, E3, E2, E4, 34, 36 and 32 corresponds closely to the embodiment of Fig. 1, which is why the same reference numerals and letters have been used. So far as the third waveguide 60 is concerned and the electron waveguide 34 are coupled via the gate region 62 so that the input ports E3, E5, the outputs E4, E6, the two electron waveguides 34 and 60 and the gate region 62 form a second structure which is substantially equivalent to that of Fig. 1. By applying suitable signals to the gate electrodes 32 and 62 a signal applied to the port E1 could for example be transferred first to the electron waveguide 34 and then subsequently to the electron waveguide 60 so that it could be extracted at the port E6. A signal applied to port E5 could be switched to port E4 and a signal applied to E3 could be switched to the port E2. In the same way a signal applied to the port E1 could be switched to the output port E4. Of course the situation can also be arranged, by control of the applied gate voltages, such that signal applied to the input ports E1, E3 or E5 are switched directly along the associated waveguides to the corresponding output ports E2, E4 or E6.

A further development of this arrangement is shown in Fig. 9. Here it will be seen that the ports E1, E3, E5, E2, E4, E6, the electron waveguides 34, 36 and 60 and the gate electrode 32 and 62 correspond in function to the circuit shown in Fig. 8, the positions of the electrodes and waveguides have simply been modified to indicate that different geometries are possible. In addition the device of Fig. 9 has been supplemented by a further waveguide 70 a further inlet port E7 and a further outlet port E8, with a further gate region 72 being provided for switching between the waveguides 60 and 70. Thus in this way the signal applied to port E7 could for example be directed to either of ports E4 or E6 (by the application of suitable gate potentials) or could be directed straight through to the port E8. Equally the signal applied to port E5 could, if desired, be directed to port E8 by applying a suitable potential to the gate 72.

The description of Figs. 8 and 9 indicate that switching devices of the present invention can readily be connected in series and in parallel.

Finally, it will be appreciated that although the present invention has been described with reference to devices where the majority carriers are electrons, inverse devices are also possible where the majority carriers are holes and the claims will also be understood to extend to such inverse devices. In this case references to electron wavefunctions and electron waveguides will be understood to refer to hole wave and hole waveguides and p-doping will be substituted for n-doping. Otherwise the devices remain basically the same.

The concept of the invention is also extremely well suited to realising logic gates.

To simplify the discussion the most fundamental case will be considered in which the coupling coefficient C ($\overline{V}$ g) which can be controlled by the gate voltage $\overline{V}$ g and the gate length Lg satisfy the condition that:

$$C \ (Vg) \ Lg = \pi/2$$

We call this condition the "ON" state.

In this condition, an electron injected into the first channel of the device of Fig. 1, i.e. into the electron waveguide 36 is completely transferred into the second channel or electron waveguide 34. If, on the other hand, there is no coupling between the channels, i.e. C ($\overline{V}$ g)=O, then an electron injected into the first channel is conducted in the first channel as it is.

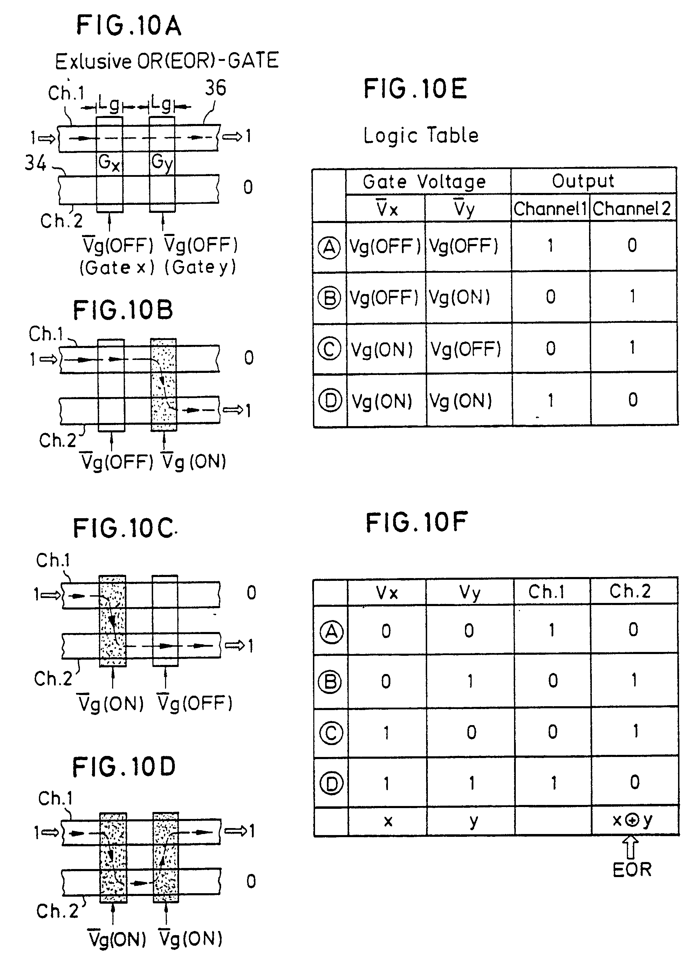

Fig. 10 shows how the switching device of Fig. 1 can be modified by the addition of a second gate electrode to realise the function of an exclusive OR gate.

For the sake of convenience Figs. 10A to 10D only show the central portion of Fig.1 with the two electron waveguides 34 and 36 and with two gate electrodes which have been designated here Gx and Gy.

If the two gates Gx and Gy are off, as shown in Fig. 10A, represented by the statement $\overline{V}$ g(OFF) against Gx and Gy, then a signal or electron injected into channel 1 (electron waveguide 36) as signified by the arrow 1 at the left hand side of Fig. 10A will emerge at the output of channel 1 as signified at the right hand side of Fig. 10A. No signal or electron is injected into channel 2 so that no signal or electron appears at the output thereof.

If now the gate y is turned on then the signal or electron injected into channel 1 will appear at the output of channel 2 as illustrated in Fig. 10B. Similarly, if gate y is left turned off but gate x is turned on the electron or signal applied to the input of channel 1 will appear at the output of channel 2 as shown in Fig. 10C. In both Figs. 10B and 10C no signal is present at the output of channel 1.

If in contrast, both gates x and y are turned on, as shown in Fig. 10D then the electrode or signal applied at the input to channel 1 first moves into channel 2 at the influence of gate x but then moves back to channel 1 under the influence of gate 2. Thus it appears at the output of channel 1 as shown in Fig. 10D. Since no signal is applied at the input of channel 2 there is no signal at the output of that channel.

The resulting outputs of the channels 1 and 2 are summarised in Fig. 10E for the four different possible permutations of the ON and OFF states of the gates x and y.

If we now rewrite the table of Fig. 10E setting the state $\overline{V}$ g(OFF) equal to the binary value 0 and $\overline{V}$ g (ON) equal to the binary value 1 then we obtain the table of Fig. 10F. From this we can see that binary signals ($\overline{V}$ x and $\overline{V}$ y) applied to the gates x and y result in binary signals at the output of channel 2 which correspond to a combination of the signals applied to the two gates x and y in accordance with the logic of an exclusive OR gate. To make the gate work it is of course necessary to apply the signals 1 and 0 to the channels 1 and 2 respectively which is however not regarded as a serious disadvantage, and is more than compensated for by the device's clear advantages in terms of switching speed, size and simplicity. Moreover, there is an inherent decoupling between the binary signals applied to the gates and the signals at the outputs which can be of benefit under some circumstances.

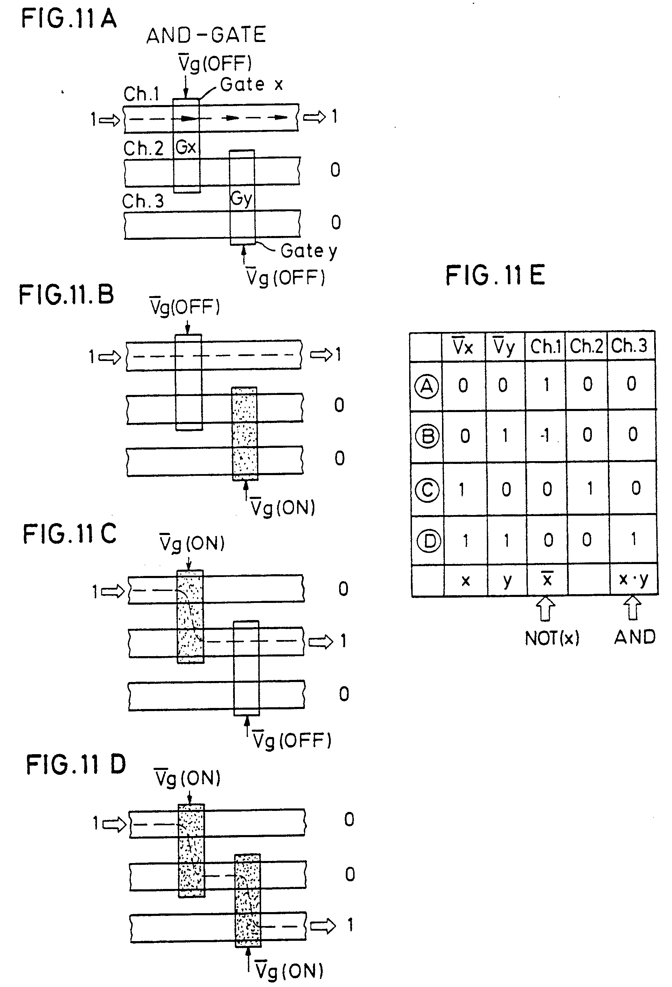

The embodiment of Fig. 11 shows a development of this basic concept based on the precise structure of the switching device of Fig. 8.

Here the three electron waveguides 34, 36 and 60 are labelled channels 1, 2 and 3 respectively and the gates 32 and 62 are labelled gates x and y (or Gx and Gy). Using the same considerations as were explained in detail in relation to Fig. 10 an AND signal can be obtained at the channel 3 output of the switching device of Fig. 8 (in relation to the signals applied to the two gates) if the signal 1 is applied to the channel 1 input and if the signal 0 (no signal) is applied to each of the channel 2 and 3 inputs.

That is to say the binary signals to be combined in accordance with the function of an AND gate are applied to the two gates x and y. The resulting logic output of channels 1, 2 and 3 is shown in table 11E. Here it will be seen that the output of channel 1 corresponds to an inverted value of the signal applied to the gate x whereas the output of channel 3 corresponds to a combination of the two binary signals applied to the gates x and y in accordance with the function of an AND gate.

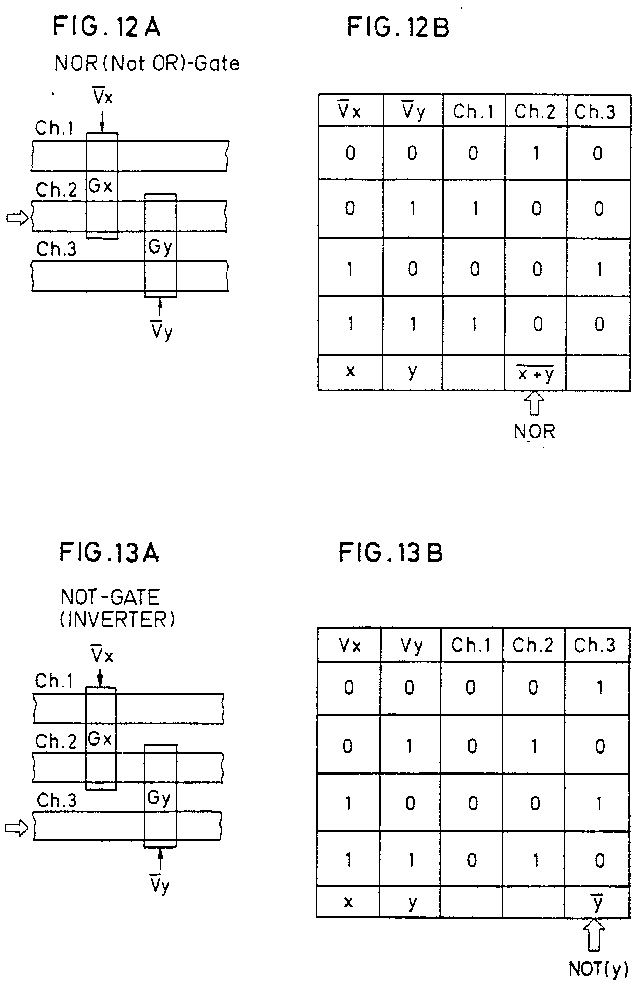

The structure of Fig. 8 is particularly interesting since it can also be used in different manners to realise further gates. Thus, Fig. 12A shows the use of the same structure to realise a NOR gate. In this case the signal 1 is applied to the input of channel 2 whereas the signal 0 (no signal) is applied to the inputs of channels 1 and 3. The two signals to be combined are again applied to the gate electrodes Gx and Gy. The truth table shows that the signals applied to the gate electrodes Gx and Gy result in an output from the channel 2 which corresponds to the combination of the two binary signals in accordance with a NOR gate.

The same structure is used in accordance with Fig. 13A to realise a NOT gate, i.e. an inversion of the binary signal applied to the gate Gy. In order to achieve this function the signal 0 has to be applied to the inputs of the two channels 1 and 2 whereas the signal 1 has to be applied to the input of channel 3.

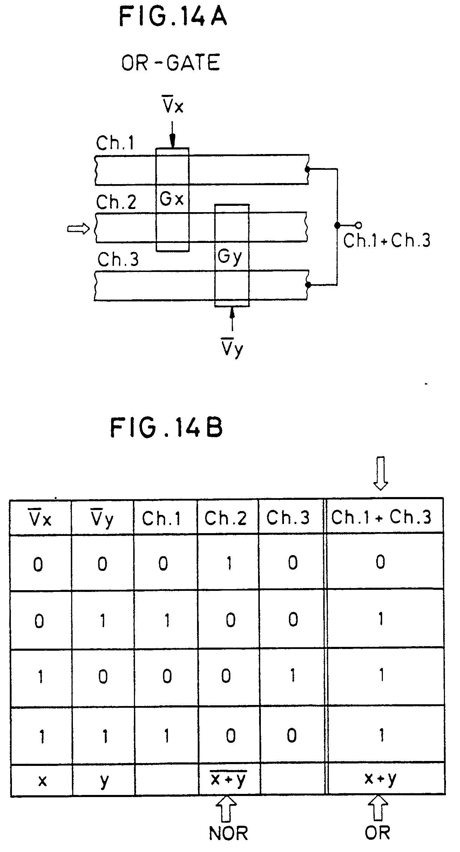

In addition, Fig. 14A shows a variation of the Fig. 12A arrangement by which an OR gate can be realised. The arrangement of the switching device of Fig. 14A is physically the same as that of the device of Fig. 8 except that the outputs of the two channels 1 and 3 (i.e. the ouptuts E2 and E6 are connected together at a common terminal (labelled here Ch1 + Ch3). In correspondence with Fig. 12A the signal 0 (no signal) is applied to the inputs of channels 1 and 3 whereas a signal 1 is applied to the input of channel 2. The output of channel 2 is of course then the same NOR signal as is achieved in the Fig. 12A arrangement, however the result of adding the outputs of channels 1 and 3 is to obtain an OR function at the common output terminal, that is to say the logic signals applied to the gates Gx and Gy result in an output as if the signals had been combined in a normal OR gate in accordance with an OR gate function.

Whereas the gates of the logic devices have been described with reference to the structures of Figs. 1 and 8 it will be understood that the gates could also be realised using a magnetic field and a narrower gate as disclosed in Fig. 4.

More complicated logic functions can also be realised in the above described manner.

The structure of Fig. 8 has the fundamental advantage that one device can be used to realise a whole variety of logic functions depending simply on the voltages applied to the inputs of the channels and to the two gates (and whether or not channel outputs are combined e.g. as in Fig. 14A).

Moreover, the logic circuits described herein can be combined together to build large scale integrated logic circuits.

## Claims

1. An electron-wave coupled semiconductor device (10), in particular a semiconductor switching device, comprising a first layer (14) of semiconducting material having a first bandgap, a second layer (16) of material formed on said first semiconducting layer (14) and having a second bandgap greater than the first said bandgap, first and second electron waveguides (34,36) formed alongside but spaced apart from each other in the first semiconducting layer (14) adjacent the boundary between this layer and said second layer (16), a gate region (32) extending over said second layer (16) transverse to and over said electron waveguides (34,36), first contact means(E1,E3) providing input connections to said first and second electron waveguides (34,36) on one side of said gate region (32) and further contact means (E2,E4) providing separate output connections from said first and second electron waveguides (34,36) on the opposite side of the gate region (32) from said first contact means (E1,E3), wherein the dimension of the electron waveguides (34,36) under said gate region (32), both along and transverse to said electron waveguides and also the dimension between said electron waveguides is smaller than the elastic mean free path for electrons at the operating temperature of the device.

2. A device in accordance with claim 1 wherein said electron waveguides (34,36) are channels formed by constricted regions of a two-dimensional electron gas, said restricted regions representing a quasi one-dimensional electron gas.

3. A device in accordance with claim 1 wherein the sub-band energy levels of the isolated electron waveguides (34,36) have the same value.

4. A device in accordance with any one of the preceding claims, characterized by means for varying the voltage applied in operation to said gate region (32).

5. A device in accordance with any one of the preceding claims, characterized in that said first contact means (E1,E3) comprises separate first and second contacts to said first and second electron waveguides (34,36).

6. A device in accordance with any one of the preceding claims 1 to 4, characterized in that said first contact means comprises a common contact (E1) to said first and second electron waveguides; and in that field generating means is provided for generating a magnetic field perpendicular to a plane containing said first and second waveguides in the region between said common contact and said gate region.

7. A device in accordance with any one of the preceding claim based on a III-V heterostructure characterized in that said first semiconductor layer (14) comprises the material layer the smaller band gap and in that said second layer (16) comprises the material having the larger band gap.

8. A device in accordance with claim 7 wherein a two or quasi one-dimensional electron gas forming said electron waveguides is formed in said first semiconductor layer (14) adjacent said second layer (16) by modulation doping of said second layer.

9. A device in accordance with claim 7 or claim 8 and based on an AlGaAs/GaAs heterostructure, characterized in that said first semiconducting layer (14) comprises an intrinsic gallium arsenide layer having a thickness in the range $1\,\mu$ to $10\,\mu$, in particular $2\,\mu$, grown on a GaAs substrate (12), preferably with buffer layers therebetween, in that said second layer (16) comprises an undoped $Al_{0.3}Ga_{0.7}As$ layer having a thickness in the range from 100 to 1000 Å and typically 200 Å; and in that a modulation doping layer (18) in the form of n-doped $Al_{0.3}Ga_{0.7}As$ is provided in said second layer, the dopant being typically silicon with a concentration in the range 1 to 3 x $10^{18}/cm^3$, wherein said modulation doping layer (18) typically has a thickness from one monolayer up to ca. 500Å and is spaced from the boundary of said GaAs layer by a distance in the range from 10 to 300 Å.

10. A device in accordance with any one of the preceding claims 6 to 9, characterized in that the region of the device on either side of said electron waveguides (34,36) and between said electron waveguides are converted to insulating material by ion implantation or ion bombardment, so as to bound said electron waveguides at the sides.

11. A device in accordance with claim 10, characterized in that cap regions (28,30) having substantially the same shape and size in plan view as the desired electron waveguides (34,36) are formed over said second layer (16).

12. A device in accordance with claim 11, characterized in that said gate electrode (32) is formed over said second layer (16) and over said cap regions (28,30).

13. A device in accordance with claim 11, characterized in that said gate region (32) is a Schottky gate, for example of gold.

14. A device in accordance with one of the preceding claims, wherein said first contact means (E1,E3) and said further contact means (E2,E4) comprise metallic contacts, for example diffused gold or germanium contacts.

15. A device in accordance with any one of the preceding claims, wherein said electron waveguides (34,36) have a thickness in the range up to 3nm (30 Å), a width in the range 2 to 3 x $10^2$nm (2 to 3 x $10^3$Å) and are separated from each other by a distance of 2 to 3 x $10^2$nm (2 to 3 x $10^3$Å).

16. A device in accordance with any one of the preceding claims, wherein said gate region (32) has a width in the length direction of said electron waveguides (34,36) of the order of magnitude of $0.3\,\mu$ and a length transverse to the electron waveguides of the order of magnitude of $1\,\mu$.

17. A device in accordance with any one of the preceding claims 1 to 6, wherein said semiconducting material is based on silicon and said first layer (14) comprises a p-doped silicon layer and said second layer (16) comprises an $SiO_2$ layer (48) with said electron waveguides being formed by a two-dimensional electron gas in said p-doped silicon layer adjacent the boundary between said p-doped silicon layer and said $SiO_2$ layer, and in that said gate region (32) comprises first, second and third gate electrodes (40,42,44), typically of aluminium or gold and wherein, in operation, the voltages applied to the first and third gate electrodes (40,44) are selected to separately confine the electron-waves and the voltage applied to the second gate electrode (42), which is disposed between the first and third gate electrodes (40,44), is varied to induce coupling between the electron-waves.

18. A device in accordance with claim 17, characterized in that the width of the second gate electrode (42) in the length direction of the electron waveguides corresponds to the coupling length $l_c$ which is the product of the speed of the electron and the transfer time for the coupling process; and in that the separation between the first and second gate electrodes (40,42) and between the second and third gate electrodes (42,44) is relatively short, for example less than 0.1 $\mu$m.

19. A device in accordance with either of the preceding claims 17 and 18, characterized in that cap regions (50,52) are formed on said $SiO_2$ layer (48), typically of metal and serve, on the application of a potential to induce electrons into the region beneath the cap regions (50,52) to form said electron waveguides (34,36), there being a further $SiO_2$ layer (54) grown on top of exposed portions of the first said $SiO_2$ layer (48) and said cap regions (50,52) and said gate electrodes (40,42,44) being applied on top of the further $SiO_2$ layer (54).

20. A device in accordance with any one of the preceding claims, wherein a plurality of electron waveguides (34,36,60) are provided and are arranged parallel to one another and spaced apart in the first semiconducting layer (14) adjacent the boundary with said second layer (16) and wherein a plurality of gate regions (32,62) are provided, each gate region extending over two adjacent electron waveguides.

21. A device comprising a series arrangement of a plurality of devices in accordance with one or more of the preceding claims.

22. A device according to one of the preceding claims but provided as an inverse structure where the majority carriers are holes.

23. Use of the semiconductor device of any one of claims 1 to 19 with an additional gate region extending over said second layer transverse to and over said electron waveguides and spaced apart from the other gate region, whereby to realise a structure capable of operating as an exclusive OR gate.

24. A device in accordance with claim 20 comprising first, second and third electron waveguides and first and second gate regions with said first gate region extending over said first and second waveguides and said second gate region extending over said second and third electron waveguides, in particular a device of this kind when used to realise the function of at least one of an AND gate, a NOR gate, a NOT gate (inverter) or an OR gate.

**Patentansprüche**

1. Eine elektronenwellengekoppelte Halbleitervorrichtung (10), insbesondere eine Halbleiterschaltvorrichtung mit einer ersten Schicht (14) aus halbleitendem Material mit einem ersten Bandabstand, einer zweiten Schicht (16) aus Material, das auf der ersten halbleitenden Schicht (14) gebildet ist und einen zweiten Bandabstand aufweist, der größer als der erste Bandabstand ist, ersten und zweiten Elektronenwellenleitern (34, 36), die längs aber beabstandet voneinander in der ersten halbleitenden Schicht (14) benachbart der Grenze zwischen dieser Schicht und der zweiten Schicht (16) gebildet sind, einem Gate-Bereich (32), der sich über der zweiten Schicht (16) quer zu und über den Elektronenwellenleitern (34, 36) erstreckt, ersten Kontaktmitteln (E1, E3), die Eingangsverbindungen zu den ersten und zweiten Elektronenwellenleitern (34, 36) auf der einen Seite des Gate-Bereiches (32) vorsehen, und weiteren Kontaktmitteln (E2, E4), die separate Ausgangsverbindungen von den ersten und zweiten Elektronenwellenleitern (34, 36) auf der gegenüberliegenden Seite des Gate-Bereiches (32) von den ersten Kontaktmitteln (E1, E3) vorsehen, wobei die Abmessung der Elektronenwellenleiter (34, 36) unter dem Gate-Bereich (32) sowohl längs als auch quer zu den Elektronenwellenleitern und auch die Abmessung zwischen den Elektronenwellenleitern kleiner als die elastische mittlere freie Weglänge für Elektronen bei der Betriebstemperatur der Vorrichtung ist.

2. Eine Vorrichtung nach Anspruch 1, wobei die Elektronenwellenleiter (34, 36) Kanäle sind, die durch eingeengte Bereiche eines zweidimensionalen Elektronengases gebildet sind, wobei die beschränkten Bereiche ein quasi eindimensionales Elektronengas darstellen.

3. Vorrichtung nach Anspruch 1, wobei die Subbandenergieniveaus der isolierten Elektronenwellenleiter (34, 36) den gleichen Wert aufweisen.

4. Eine Vorrichtung nach einem der vorhergehenden Ansprüche,

   gekennzeichnet durch Mittel zum Variieren der im Betrieb an den Gate-Bereich (32) angelegten Spannung.

5. Eine Vorrichtung nach einem der vorhergehenden Ansprüche,

   dadurch gekennzeichnet,
   daß das erste Kontaktmittel (E1, E3) separate erste und zweite Kontakte zu den ersten und zweiten Elektronenwellenleitern (34, 36) umfaßt.

6. Eine Vorrichtung nach einem der vorhergehenden Ansprüche 1 bis 4,

   dadurch gekennzeichnet,
   daß das erste Kontaktmittel einen gemeinsamen Kontakt (E1) zu den ersten und zweiten Elektronenwellenleitern umfaßt, und daß ein Feldgeneriermittel vorgesehen ist, um ein Magnetfeld senkrecht zu einer Ebene zu generieren, die die ersten und zweiten Wellenleiter enthält, in dem Bereich zwischen dem gemeinsamen Kontakt und dem Gate-Bereich.

7. Eine Vorrichtung nach einem der vorhergehenden Ansprüche, auf Basis einer III-V-Heterostruktur,

   dadurch gekennzeichnet,
   daß die erste Halbleiterschicht (14) das Material mit dem kleineren Bandabstand umfaßt, und daß die zweite Schicht (16) das Material mit dem größeren Bandabstand umfaßt.

8. Eine Vorrichtung nach Anspruch 7, wobei ein zwei- oder quasi eindimensionales Elektronengas, das die Elektronenwellenleiter bildet, in der ersten Halbleiterschicht (14) benachbart der zweiten Schicht (16) durch Modulationsdotieren der zweiten Schicht gebildet ist.

9. Eine Vorrichtung nach Anspruch 7 oder Anspruch 8 und auf Basis einer AlGaAs/GaAs-Heterostruktur,

   dadurch gekennzeichnet,
   daß dies erste halbleitende Schicht(14) eine intrinsische Galliumarsenidschicht mit einer Dicke im Bereich von $1\mu$ bis $10\mu$, insbesondere $2\mu$, umfaßt, die auf ein GaAs-Substrat 12 aufgewachsen ist, vorzugsweise mit Pufferschichten dazwischen, daß die zweite Schicht (16) eine undotierte $Al_{0,3}Ga_{0,7}As$-Schicht mit einer Dicke im Bereich von 100 bis 1000 Å und typischerweise 200 Å umfaßt, und daß eine Modulationsdotierungsschicht (18) in der Form von n-dotiertem $Al_{0,3}Ga_{0,7}As$ in der zweiten Schicht vorgesehen ist, wobei der Dopant typischerweise Silizium mit einer Konzentration im Bereich von 1 bis $3 \times 10^{18}/cm^3$ ist und die Modulationsdotierungsschicht (18) typischerweise eine Dicke von einer Monoschicht bis zu circa 500 Å aufweist und von der Grenze der GaAs-Schicht um einen Abstand im Bereich von 10 bis 300 Å beabstandet ist.

10. Eine Vorrichtung nach einem der vorhergehenden Ansprüche 6 bis 9,

    dadurch gekennzeichnet,
    daß die Bereiche der Vorrichtung auf jeder Seite der Elektronenwellenleiter (34, 36) und zwischen den Elektronenwellenleitern zu isolierendem Material durch Ionenimplantation oder Ionenbombardierung umgewandelt sind, um die Elektronenwellenleiter an den Seiten zu begrenzen.

11. Eine Vorrichtung nach Anspruch 10,

    dadurch gekennzeichnet,
    daß die Deckbereiche (28, 30) mit im wesentlichen der gleichen Form und Größe in der Draufsicht wie die gewünschten Elektronenwellenleiter (34, 36) über der zweiten Schicht (16) gebildet sind.

12. Vorrichtung nach Anspruch 11,

dadurch gekennzeichnet,
daß die Gate-Elektrode (32) über der zweiten Schicht (16) und über den Deckbereichen (28, 30) gebildet ist.

**13.** Vorrichtung nach Anspruch 11,

dadurch gekennzeichnet,
daß der Gate-Bereich (32) ein Schottky-Gate, beispielsweise aus Gold ist.

**14.** Eine Vorrichtung nach einem der vorhergehenden Ansprüche, wobei die ersten Kontaktmittel (E1, E3) und die zweiten Kontaktmittel (E2, E4) metallische Kontakte, beispielsweise diffundierte Gold- oder Germaniumkontakte umfassen.

**15.** Vorrichtung nach einem der vorhergehenden Ansprüche, wobei die Elektronenwellenleiter (34, 36) eine Dicke im Bereich bis zu 3 nm (30 Å), eine Breite im Bereich von 2 bis 3 x$10^2$ nm (2 bis 3 x $10^3$ Å) aufweisen und voneinander um einen Abstand von 2 bis 3 x $10^2$ nm (2 bis 3 x $10^3$ Å) getrennt sind.

**16.** Eine Vorrichtung nach einem der vorhergehenden Ansprüche, wobei der Gate-Bereich (32) eine Breite in Längsrichtung der Elektronenwellenleiter (34, 36) in der Größenordnung von 0,3 $\mu$ und eine Länge quer zu den Elektronenwellenleitern in der Größenordnung von 1$\mu$ aufweist.

**17.** Eine Vorrichtung nach einem der vorhergehenden Ansprüche 1 bis 6, wobei das halbleitende Material auf Silizium basiert und die erste Schicht (14) eine p-dotierte Siliziumschicht und die zweite Schicht (16) eine $SiO_2$-Schicht (48) umfaßt, die Elektronenwellenleiter durch ein zweidimensionales Elektronengas in der p-dotierten Siliziumschicht benachbart der Grenze zwischen der p-dotierten Siliziumschicht und der $SiO_2$-Schicht gebildet sind, und in der der Gate-Bereich (32) erste, zweite und dritte Gate-Elektroden (40, 42, 44) typischerweise aus Aluminium oder Gold umfaßt, und wobei im Betrieb die an die ersten und dritten Gate-Elektroden (40, 44) angelegten Spannungen ausgewählt sind, um getrennt die Elektronenwellen zu begrenzen, und die an die zweite Gate-Elektrode (42), welche zwischen den ersten und dritten Gate-Elektroden (40, 44) angeordnet ist, angelegte Spannung variiert wird, um eine Kopplung zwischen den Elektronenwellen zu induzieren.

**18.** Eine Vorrichtung nach Anspruch 17,

dadurch gekennzeichnet,
daß die Breite der zweiten Gate-Elektrode (42) in der Längsrichtung der Elektronenwellenleiter der Kopplungslänge $l_c$ entspricht, welche das Produkt der Elektronengeschwindigkeit und der Transferzeit für den Kopplungsprozeß ist, und daß der Abstand zwischen den ersten und zweiten Gate-Elektroden (40, 42) und zwischen den zweiten und dritten Gate-Elektroden (42, 44) relativ kurz ist, beispielsweise weniger als 0,1 $\mu$m.

**19.** Eine Vorrichtung nach einem der vorhergehenden Ansprüche 17 und 18,

dadurch gekennzeichnet,
daß Deckbereiche (50, 52) auf der $SiO_2$-Schicht (48) gebildet sind, typischerweise aus Metall, und dazu dienen, beim Anlegen eines Potentials Elektronen in den Bereich unter den Deckbereichen (50, 52) zu induzieren, um die Elektronenwellenleiter (34, 36) zu bilden, wobei eine weitere $SiO_2$-Schicht (54) auf die Oberseite der freiliegenden Teile der ersten $SiO_2$-Schicht (48) und die Deckbereiche (50, 52) aufgewachsen ist, und die Gate-Elektroden (40, 42, 44) auf die Oberseite der weiteren $SiO_2$-Schicht (54) aufgebracht sind.

**20.** Eine Vorrichtung nach einem der vorhergehenden Ansprüche, wobei eine Vielzahl von Elektronenwellenleitern (34, 36, 60) vorgesehen und parallel zueinander und beabstandet in der ersten halbleitende Schicht (14) benachbart der Grenze zur zweiten Schicht (16) angeordnet ist, und wobei eine Vielzahl von Gate-Bereichen (32, 62) vorgesehen ist, wobei sich jeder Gate-Bereich über zwei benachbarte Elektronenwellenleiter erstreckt.

**21.** Eine Vorrichtung mit einer Reihenanordnung einer Vielzahl von Vorrichtungen gemäß einem oder mehreren der vorhergehenden Ansprüche.

**22.** Eine Vorrichtung nach einem der vorhergehenden Ansprüche, aber als eine inverse Struktur vorgesehen, wobei die Majoritätsträger Löcher sind.

**23.** Gebrauch der Halbleitervorrichtung nach einem der Ansprüche 1 bis 19 mit einem zusätzlichen Gate-Bereich, der sich über der zweiten Schicht quer zu und über den Elektronenwellenleitern und beabstandet von dem anderen Gate-Bereich erstreckt, wodurch eine Struktur verwirklicht wird, die als ein Exklusiv-ODER-Gatter arbeiten kann.

**24.** Eine Vorrichtung nach Anspruch 20 mit ersten, zweiten und dritten Elektronenwellenleitern und ersten und zweiten Gate-Bereichen, wobei sich der erste Gate-Bereich über die ersten und zweiten Wellenleiter und der zweite Gate-Bereich sich über die zweiten und dritten Elektronenwellenleiter erstreckt, insbesondere eine Vorrichtung dieser Sorte, wenn sie verwendet wird, um die Funktion von wenigstens einem von einem UND-Gatter, einem WEDER-NOCH-Gatter, einem NICHT-Gatter (Inverter) oder einem ODER-Gatter zu verwirklichen.

**Revendications**

**1.** Un dispositif à semiconducteurs à couplage par des ondes d'électrons (10), en particulier un dispositif de commutation à semiconducteurs, comprenant une première couche (14) de matériau semiconducteur ayant une première bande interdite, une seconde couche (16) de matériau formée sur la première couche semiconductrice (14) et ayant une seconde bande interdite supérieure à la première bande interdite, des premier et second guides d'ondes d'électrons (34, 36) formés côte à côte, mais de façon mutuellement espacée, dans la première couche semiconductrice (14), en position adjacente à la frontière entre cette couche et la seconde couche (16), une région de grille (32) s'étendant sur la seconde couche (16) transversalement aux guides d'ondes d'électrons (34, 36) et sur ces derniers, des premiers moyens de contact (E1, E3) établissant des connexions d'entrée pour les premier et second guides d'ondes d'électrons (34, 36), d'un côté de la région de grille (32), et des moyens de contact supplémentaires (E2, E4) établissant des connexions de sortie séparées pour les premier et second guides d'ondes d'électrons (34, 36) du côté opposé de la région de grille (32), par rapport aux premiers moyens de contact (E1, E3), dans lequel la dimension des guides d'ondes d'électrons (34, 36) sous la région de grille (32), aussi bien dans la direction longitudinale que dans la direction transversale des guides d'ondes d'électrons, et également la dimension entre les guides d'ondes d'électrons, sont inférieures au libre parcours moyen élastique pour des électrons à la température de fonctionnement du dispositif.

**2.** Un dispositif selon la revendication 1, dans lequels les guides d'ondes d'électrons (34, 36) sont des canaux formés par des régions de constriction d'un gaz d'électrons bidimensionnel, ces régions restreintes représentant un gaz d'électrons quasi-unidimensionnel.

**3.** Un dispositif selon la revendication 1, dans lequel les niveaux d'énergie de sous-bandes des guides d'ondes d'électrons isolés (34, 36) ont la même valeur.

**4.** Un dispositif selon l'une quelconque des revendications précédentes, caractérisé par des moyens pour faire varier la tension qui est appliquée au cours du fonctionnement à la région de grille (32).

**5.** Un dispositif selon l'une quelconque des revendications précédentes, caractérisé en ce que les premiers moyens de contact (E1, E3) comprennent des premier et second contacts séparés avec les premier et second guides d'ondes d'électrons (34, 36).

**6.** Un dispositif selon l'une quelconque des revendications 1 à 4 précédentes, caractérisé en ce que les premiers moyens de contact comprennent un contact commun (E1) avec les premier et second guides d'ondes d'électrons; et en ce que des moyens de génération de champ sont incorporés pour générer un champ magnétique perpendiculaire à un plan contenant les premier et second guides d'ondes, dans la région qui est située entre le contact commun et la région de grille.

**7.** Un dispositif selon l'une quelconque des revendications précédentes, basé sur une hétérostructure III-V, caractérisé en ce que la première couche de semiconducteur (14) est constituée par le matériau ayant la bande interdite inférieure, et en ce que la seconde couche (16) est constituée par le matériau ayant la bande interdite supérieure.

**8.** Un dispositif selon la revendication 7, dans lequel un gaz d'électrons bidimensionnel ou quasi-unidimensionnel formant les guides d'ondes d'électrons, est formé dans la première couche de semiconducteur (14) en position adjacente à la seconde couche (16), par dopage modulé de la seconde couche.

**9.** Un dispositif selon la revendication 7 ou la revendication 8 et basé sur une hétérostructure AlGaAs/ GaAs, caractérisé en ce que la première couche semiconductrice (14) comprend une couche d'arséniure de gallium intrinsèque ayant une épaisseur dans la plage de 1 µm à 10 µm, en particulier 2 µm, que l'on a fait croître sur un substrat en GaAs (12), de préférence avec des couches tampons entre eux, en ce que la seconde couche (16) comprend une couche d'$Al_{0,3}Ga_{0,7}As$ non dopée, ayant une épaisseur dans la plage de 100 à 1000 Å, et d'une valeur caractéristique de 200 Å; et en ce qu'une couche à dopage modulé (18), sous la forme d'$Al_{0,3}Ga_{0,7}As$ dopé avec le type n, est formée dans la seconde couche, le dopant étant de façon caractéristique du silicium avec une concentration dans la plage de 1 à 3 x $10^{18}$/cm$^3$, cette couche à dopage modulé (18) ayant de façon caractéristique une épaisseur allant d'une couche monomoléculaire jusqu'à environ 500 Å et étant espacée de la frontière de la couche de GaAs d'une distance dans la plage de 10 à 300 Å.

10. Un dispositif selon l'une quelconque des revendications 6 à 9 précédentes, caractérisé en ce que les régions du dispositif se trouvant de part et d'autre des guides d'ondes d'électrons (34, 36) et entre les guides d'ondes d'électrons sont converties en un matériau isolant par implantation ionique ou bombardement ionique, de façon à limiter les guides d'ondes d'électrons sur les côtés.

11. Un dispositif selon la revendication 10, caractérisé en ce que des régions de recouvrement (28, 30) ayant pratiquement la même forme et la même taille, en vue en plan, que les guides d'ondes d'électrons (34, 36) désirés sont formées sur la seconde couche (16).

12. Un dispositif selon la revendication 11, caractérisé en ce que l'électrode de grille (32) est formée sur la seconde couche (16) et sur les régions de recouvrement (28, 30).

13. Un dispositif selon la revendication 11, caractérisé en ce que la région de grille (32) est une grille Schottky, par exemple en or.

14. Un dispositif selon l'une des revendications précédentes, dans lequel les premiers moyens de contact (E1, E3) et les moyens de contact supplémentaires (E2, E4) comprennent des contacts métalliques, par exemple des contacts diffusés en or ou en germanium.

15. Un dispositif selon l'une quelconque des revendications précédentes, dans lequel les guides d'ondes d'électrons (34, 36) ont une épaisseur dans la plage allant jusqu'à 3 nm (30 Å), une largeur dans la plage de 2 à 3 x $10^2$ nm (2 à 3 x $10^3$ Å), et ils sont mutuellement séparés d'une distance de 2 à 3 x $10^2$ nm (2 à 3 x $10^3$ Å).

16. Un dispositif selon l'une quelconque des revendications précédentes, dans lequel la région de grille (32) a une largeur, dans la direction de la longueur des guides d'ondes d'électrons (34, 36) d'un ordre de grandeur de 0,3 µm, et une longueur dans la direction transversale des guides d'ondes d'électrons d'un ordre de grandeur de 1 µm.

17. Un dispositif selon l'une quelconque des revendications 1 à 6 précédentes, dans lequel le matériau semiconducteur est basé sur le silicium et la première couche (14) consiste en une couche de silicium dopé avec le type p, et la seconde couche (16) consiste en une couche de $SiO_2$ (48), avec les guides d'ondes d'électrons formés par un gaz d'électrons bidimensionnel dans la couche de silicium dopé avec le type p, en position adjacente à la frontière entre la couche de silicium dopé avec le type p et la couche de $SiO_2$, et dans lequel la région de grille (32) comprend des première, seconde et troisième électrodes de grille (40, 42, 44), consistant de façon caractéristique en aluminium ou en or, et dans lequel, pendant le fonctionnement, les tensions qui sont appliquées aux première et troisième électrodes de grille (40, 44) sont sélectionnées de façon à confiner séparément les ondes d'électrons, et la tension qui est appliquée à la seconde électrode de grille (42), qui est disposée entre les première et troisième électrodes de grille (40, 44), est soumise à une variation pour induire un couplage entre les ondes d'électrons.

18. Un dispositif selon la revendication 17, caractérisé en ce que la largeur de la seconde électrode de grille (42) dans la direction de la longueur des guides d'ondes d'électrons correspond à la longueur de couplage $l_c$, qui est le produit de la vitesse de l'électron et du temps de transfert pour le processus de couplage; et en ce que la séparation entre les première et seconde électrodes de grille (40, 42) et entre les seconde et troisième électrodes de grille (42, 44) est relativement courte, par exemple inférieure à 0,1 µm.

19. Un dispositif selon l'une quelconque des revendications 17 et 18 précédentes, caractérisé en ce que des régions de recouvrement (50, 52) sont formées sur la couche de $SiO_2$ (48), ces régions consistant de façon caractéristique en métal et ayant pour fonction, au moment de l'application d'un potentiel, d'induire des électrons dans la région située au-dessous des régions de recouvrement (50, 52), pour former les guides d'ondes d'électrons (34, 36), une

couche de $SiO_2$ supplémentaire (54) étant formée par croissance sur la surface supérieure de parties à nu de la première couche de $SiO_2$ (48) et des régions de recouvrement (50, 52), et les électrodes de grille (40, 42, 44) étant appliquées sur la surface supérieure de la couche de $SiO_2$ supplémentaire (54).

20. Un dispositif selon l'une quelconque des revendications précédentes, dans lequel un ensemble de guides d'ondes d'électrons (34, 36, 60) sont formés et sont disposés parallèlement les uns aux autres avec un espacement mutuel, dans la première couche semiconductrice (14), en position adjacente à la frontière avec la seconde couche (16), et dans lequel un ensemble de régions de grille (32, 62) sont formées, chaque région de grille s'étendant sur deux guides d'ondes d'électrons adjacents.

21. Un dispositif comprenant une combinaison en série d'un ensemble de dispositifs conformes à une ou plusieurs des revendications précédentes.

22. Un dispositif selon l'une des revendications précédentes, mais réalisé sous la forme d'une structure inverse dans laquelle les porteurs majoritaires sont des trous.

23. Utilisation du dispositif à semiconducteurs de l'une quelconque des revendications 1 à 19 avec une région de grille supplémentaire s'étendant sur la seconde couche, transversalement aux guides d'ondes d'électrons et au-dessus de ces derniers, et étant espacée de l'autre région de grille, pour réaliser ainsi une structure capable de fonctionner comme une porte OU-EXCLUSIF.

24. Un dispositif selon la revendication 20, comprenant des premier, second et troisième guides d'ondes d'électrons et des première et seconde régions de grille, la première région de grille s'étendant sur les premier et second guides d'ondes et la seconde région de grille s'étendant sur les second et troisième guides d'ondes d'électrons, et en particulier un dispositif de cette sorte lorsqu'il est utilisé pour remplir la fonction d'au moins une porte parmi une porte ET, une porte NON-OU, une porte NON (inverseur) ou une porte OU.

**FIG.1**

**FIG.2**

**FIG.3**

EP 0 441 156 B1

**FIG.4**

EP 0 441 156 B1

FIG.5

FIG.6

FIG.7

EP 0 441 156 B1

**FIG.8**

EP 0 441 156 B1

**FIG.9**

EP 0 441 156 B1

## FIG.10A

Exlusive OR(EOR)-GATE

## FIG.10B

## FIG.10C.

## FIG.10D

## FIG.10E

Logic Table

| | Gate Voltage | | Output | |
|---|---|---|---|---|
| | $\bar{V}x$ | $\bar{V}y$ | Channel1 | Channel2 |
| Ⓐ | Vg(OFF) | Vg(OFF) | 1 | 0 |
| Ⓑ | Vg(OFF) | Vg(ON) | 0 | 1 |
| Ⓒ | Vg(ON) | Vg(OFF) | 0 | 1 |
| Ⓓ | Vg(ON) | Vg(ON) | 1 | 0 |

## FIG.10F

| | Vx | Vy | Ch.1 | Ch.2 |
|---|---|---|---|---|
| Ⓐ | 0 | 0 | 1 | 0 |
| Ⓑ | 0 | 1 | 0 | 1 |
| Ⓒ | 1 | 0 | 0 | 1 |
| Ⓓ | 1 | 1 | 1 | 0 |
| | x | y | | x⊕y |

EOR

EP 0 441 156 B1

FIG.11 A

AND-GATE

FIG.11.B

FIG.11 C

FIG.11 D

FIG.11 E

| | $\overline{V}x$ | $\overline{V}y$ | Ch.1 | Ch.2 | Ch.3 |
|---|---|---|---|---|---|
| Ⓐ | 0 | 0 | 1 | 0 | 0 |
| Ⓑ | 0 | 1 | -1 | 0 | 0 |
| Ⓒ | 1 | 0 | 0 | 1 | 0 |
| Ⓓ | 1 | 1 | 0 | 0 | 1 |
| | x | y | $\overline{x}$ | | x·y |

NOT(x)     AND

25

## FIG. 12 A

NOR (Not OR)-Gate

## FIG. 12 B

| $\overline{V}x$ | $\overline{V}y$ | Ch.1 | Ch.2 | Ch.3 |
|---|---|---|---|---|
| 0 | 0 | 0 | 1 | 0 |
| 0 | 1 | 1 | 0 | 0 |
| 1 | 0 | 0 | 0 | 1 |
| 1 | 1 | 1 | 0 | 0 |
| x | y | | $\overline{x+y}$ | |

NOR

## FIG. 13 A

NOT-GATE
(INVERTER)

## FIG. 13 B

| $Vx$ | $Vy$ | Ch.1 | Ch.2 | Ch.3 |
|---|---|---|---|---|
| 0 | 0 | 0 | 0 | 1 |
| 0 | 1 | 0 | 1 | 0 |
| 1 | 0 | 0 | 0 | 1 |
| 1 | 1 | 0 | 1 | 0 |
| x | y | | | $\overline{y}$ |

NOT(y)

# FIG.14A

## OR-GATE

$\overline{V}x$

Ch.1

Gx

Ch.2

Ch.3

Gy

Ch.1+Ch.3

$\overline{V}y$

# FIG.14B

| $\overline{V}x$ | $\overline{V}y$ | Ch.1 | Ch.2 | Ch.3 | Ch.1+Ch.3 |
|---|---|---|---|---|---|
| 0 | 0 | 0 | 1 | 0 | 0 |
| 0 | 1 | 1 | 0 | 0 | 1 |
| 1 | 0 | 0 | 0 | 1 | 1 |
| 1 | 1 | 1 | 0 | 0 | 1 |
| x | y | | $\overline{x+y}$ | | x+y |

NOR

OR